# EUROPÄISCHE PATENTSCHRIFT

(11) **EP 0 548 689 B1**
(45) Veröffentlichungstag und Bekanntmachung des Hinweises auf die Patenterteilung: **03.09.1997**
(21) Anmeldenummer: 92121053.0
(22) Anmeldetag: 10.12.1992
(51) Int. Cl.: G01R 23/16, G01V 1/00, G01H 3/08

(54) **Verfahren zum Detektieren und Unterscheiden weit entfernter Hubschrauber von anderen Fahrzeugen**
Process for detecting and discriminating helicopters from other vehicles at a distance
Procédé pour détecter et reconnaître des hélicoptères à grande distance des autres véhicules

(30) Priorität: 23.12.1991 DE 4142906
(43) Veröffentlichungstag der Anmeldung: 30.06.1993
(73) Patentinhaber: STN ATLAS Elektronik GmbH, D-28305 Bremen (DE)
(72) Erfinder: Fischer, Johannes, Dipl.-Ing., W-2804 Lilienthal (DE); Nick, Klaus-Peter, Dr., W-2807 Achim (DE)

(56) Entgegenhaltungen:
- DE-A- 3 929 077
- FR-A- 2 599 860
- ELECTRONICS & WIRELESS WORLD Bd. 95, Nr. 1641 , August 1989 , SURREY GB Seiten 678 - 680 'FFT analysis without tears'
- ICASSP 82 Bd. 2 , 3. Mai 1982 , PARIS, FRANCE Seiten 1124 - 1127 J. SCHILLER 'Detection and bearing angle estimation of low-flying aircraft by acoustical means'
- JOURNAL OF THE ACOUSTICAL SOCIETY OF AMERICA Bd. 92, Nr. 3 , September 1992 , NEW YORK US Seiten 1403 - 1407 B. G. FERGUSON 'A ground-based narrow-band passive acoustic technique for estimating the altitude and speed of a propeller-driven aircraft'
- IEEE ACOUSTICS, SPEECH, AND SIGNAL PROCESSING MAGAZINE Bd. 30, Nr. 5 , Oktober 1982 , NEW YORK US Seiten 747 - 750 M. J. HINICH 'Detecting a hidden periodic signal when its period is unknown'

## Beschreibung

Die Erfindung betrifft ein Verfahren sowie eine Vorrichtung zum Detektieren und Unterscheiden in der Luft befindlicher Hubschrauber von anderen Fahrzeugen, der im Oberbegriff des Anspruchs 1 bzw. 10 genannten Art.

Bei militärischen Aktionen sind Hubschrauber eine große Bedrohung. Deshalb ist es wünschenswert, Hubschrauber frühzeitig zu detektieren, um Gegenmaßnahmen einleiten zu können. Insbesondere werden Hubschrauber zum Bekämpfen von Fahrzeugen, z.B. Panzern, Oberflächenschiffen, U-Booten, eingesetzt, da sie schnell und wendig ihr Ziel erreichen und vom angegriffenen Fahrzeug schwer frühzeitig zu entdecken sind.

Auffällig ist das vom Hubschrauber abgestrahlte Betriebsgeräusch, wenn er schwebt oder fliegt, wobei dessen signifikante Spektrallinien im niederfrequenten Bereich vorwiegend durch seinen Hauptrotor und im höherfrequenten Bereich auch durch seinen Heckrotor verursacht werden. Deshalb wird das Frequenzspektrum des abgestrahlten Geräusches eines Hubschraubers nach dem Empfang u.a. bezüglich Hauptrotor- und Heckrotorfrequenz und deren Harmonischen ausgewertet, um einen Hubschrauber zu detektieren, zu orten und ggf. zu identifizieren. Es ist aus der englischen Patentanmeldung 21 04 218 bekannt, mit Hilfe der Cepstrum-Analyse des Frequenzspektrums und des Mustervergleichs mit bekannten Cepstren einen Hubschrauber zu detektieren. In der DE-PS 28 29 239 wird ebenfalls primär das Frequenzspektrum zur Identifizierung des Hubschraubertyps ausgewertet und daraus sekundär die Detektion abgeleitet.

Im niederfrequenten Bereich des Frequenzspektrums findet sich die Hauptrotorfrequenz, im höherfrequenten Bereich die Heckrotorfrequenz. Aus ihrem Verhältnis wird in der DE-OS 39 29 077 der Hubschraubertyp durch Vergleich mit bekannten abgespeicherten Werten für verschiedene Hubschraubertypen ermittelt. Erst nachdem ein Hubschraubertyp identifiziert ist, kann die Detektion des Hubschraubers gemeldet werden.

Es ist Aufgabe der vorliegenden Erfindung, ein Verfahren sowie eine Vorrichtung der im Oberbegriff des Anspruchs 1 bzw. 10 genannten Art zu schaffen, bei dem die Detektion eines Hubschraubers nicht über eine Typidentifizierung durchgeführt wird, sondern bei dem andere spektrale Merkmale des Hubschraubergeräuschs benutzt werden, um frühzeitig vor noch weit entfernten Hubschraubern warnen zu können.

Diese Aufgabe wird erfindungsgemäß durch die im Kennzeichenteil des Anspruchs 1 bzw. 10 genannten Merkmale gelöst. Die Erfindung geht dabei von der Erkenntnis aus, daß im Gegensatz zu allen anderen Fahrzeugen das Betriebsgeräusch des Hubschraubers extrem schmalbandige Spektrallinien aufweist, die sich im niederfrequenten Bereich mit geringer Dämpfung ausbreiten. Ein stabiles Flugverhalten des Hubschraubers ist nur dann möglich, wenn die Drehzahl seines Hauptrotors innerhalb geringer Toleranzen konstant ist. Unabhängig von der Fluggeschwindigkeit drehen beide Rotoren mit konstanter Geschwindigkeit und verursachen im Frequenzspektrum eine niederfrequente, frequenzkonstante Grundwelle und höherfrequente, frequenzkonstante Harmonische. Im Gegensatz zu den herkömmlichen Verfahren wird erfindungsgemäß das Frequenzspektrum im niederfrequenten Bereich allein daraufhin untersucht, ob sich dort Spektrallinien mit einer extrem schmalen Bandbreite finden, nämlich mit einer Frequenzbreite, die aus den zugelassenen Abweichungen der Hauptrotordrehzahl eines Hubschraubers abgeleitet wurde. Bei welcher Frequenz die ermittelte Grundwelle dabei liegt und ob - wenn überhaupt - Oberwellen auftreten, ist völlig unerheblich. Wesentlich ist allein, daß die Frequenzbreite der Spektrallinie nicht größer ist, als die kurzzeitigen, flugdynamisch maximal zugelassenen Abweichungen der Hauptrotordrehzahl. Das sind z. B. zwei Prozent der Mittenfrequenz, wenn die Rotordrehzahl um zwei Prozent schwanken darf. Das bedeutet bei einer Spektrallinie von 10 Hz eine Frequenzbreite von 0,2 Hz. Alle anderen Fahrzeuge, die auch Spektrallinien in ihrem Geräuschspektrum aufweisen, zeigen bei weitem nicht die erforderliche, typische Frequenzkonstanz. Ihre Spektrallinien schwanken beispielsweise während eines Zeitintervalls von 2 s um wesentlich mehr als nur 0,2 Hz und verteilen damit ihre Energie in ein breites Band. Das bedeutet, daß sie nur zum Störhintergrund beitragen. Für die Praxis ist es nur erforderlich, daß eine Hubschrauberspektrallinie im Pegel größer als die durch andere Fahrzeuge hervorgerufene Störung ist.

Als Unterscheidungsmerkmal zwischen Hubschrauber und sonstigen Fahrzeugen wird die konstante Drehzahl beim Hubschrauber benutzt, die bei anderen Fahrzeugen weder notwendig noch gefordert ist, und auch bei diesen Fahrzeugen nicht auftritt, da in aller Regel deren Fahrzeuggeschwindigkeit über Variation der Antriebsdrehzahl verändert wird.

Bei dem erfindungsgemäßen Verfahren wird nicht die Lage der Mittenfrequenz der Spektrallinie bestimmt, sondern nur festgestellt, ob die Spektrallinie eine gewisse Bandbreite nicht überschreitet. Wenn die Hubschrauberdrehzahl während des Empfangs überhaupt nicht schwankt, liefert eine diskrete Fourier-Transformation über das betrachtete Zeitintervall eine Spektrallinie mit der Bandbreite Null. Ändert sich während dieses kurzen Zeitintervalls die Drehzahl in der vom Konstrukteur zugelassenen Toleranz, weist die Spektrallinie höchstens eine Bandbreite von der Größe der vorgegebenen Frequenzbreite auf. Dabei interessiert die exakte absolute Lage der Mittenfrequenz nicht, da die Detektion nicht auf dem Auffinden von Harmonischen der Grundwelle beruht.

Eine Geschwindigkeitsänderung des Hubschraubers wird nicht durch Variation der Drehzahl seines Hauptrotors bewirkt, sondern allein durch Anstellen seiner Blätter, so daß Geschwindigkeitsänderungen lediglich zu einem Verschieben der Spektrallinie(n) aufgrund des Dopplereffekts führen. Die Änderung des Dopplereffekts und dadurch bewirkte geringe Verbreitung der Spektrallinien ist aber bei der Detektion weit entfernter Hubschrauber im Tiefflug vernachlässigbar, da sich die Radialkomponente der Fluggeschwindigkeit selbst beim direkten Anflug nicht wesentlich ändert. Besonders vorteilhaft ist weiterhin, daß die Detektion des Hubschraubers bereits aufgrund einer einzigen beliebigen Spektrallinie erfolgen kann, unabhängig davon, ob es die Grundwelle oder eine der harmonischen Spektrallinien ist, so daß Wetter- und Ausbreitungseinflüsse die Detektion nicht beeinflussen. Eine Bestimmung der Frequenz der Spektrallinien und eine weitere Auswertung bezüglich ihrer Entstehung wird für die Detektion nicht benötigt, so daß der Geräteaufwand sowie Rechen- und Zeitaufwand minimal sind.

Durch die Wahl des Zeitintervalls wird die untere Frequenzgrenze und die maximale Frequenzauflösung für das Frequenzspektrum festgelegt. Je länger das Zeitintervall, desto schmaler das Frequenzintervall unterscheidbarer benachbarter Spektrallinien, also desto feiner die Frequenzauflösung. Das Zeitintervall muß mindestens so lang sein, daß sein Reziprokwert gleich der vorgegebenen Frequenzbreite für zugelassene Frequenzschwankungen der Spektrallinie ist. Typisch liegen die Frequenzen von Spektrallinien, die den Hauptrotoren von Hubschraubern zuzuordnen sind, im Frequenzbereich von ca. 8 bis 35 Hz. Bei einer zugelassenen Toleranz für die Hauptrotordrehzahl von zwei Prozent beträgt die Frequenzbreite 0,16 bis 0,7 Hz, also kleiner 1 Hz. Somit ist das Zeitintervall mindestens eine Sekunde lang zu wählen. Spektrallinien, die vom Betriebsgeräusch anderer Fahrzeuge verursacht sind, haben eine wesentlich größere Frequenzbreite, da ihre Drehzahlkonstanz innerhalb des Zeitintervalls von einer Sekunde nicht mit der bei Hubschraubern vergleichbar ist.

Die besonderen Vorteile des erfindungsgemäßen Verfahrens liegen insbesondere darin, daß die Detektion in einem sehr tieffrequenten Bereich durchgeführt wird, so daß vom Hubschrauber sich ausbreitende Schallwellen in diesem Frequenzbereich in wesentlich größeren Entfernungen noch empfangen werden können als im übrigen gesamten Frequenzbereich, da die Ausbreitungsdämpfung zu höheren Frequenzen hin stark zunimmt und die Schallbeugung ab. Die geringe Übertragungsdämpfung und die gute Beugung um Hindernisse für tieffrequente Schallwellen kann auch deshalb voll ausgenutzt werden, da bereits eine einzige erkannte schmale Spektrallinie die Detektion liefert und nicht das übrige Frequenzspektrum nach dazu harmonischen Spektrallinien o. ä. abgesucht werden muß. Diese Vergrößerung der Reichweite gegenüber bekannten Verfahren bringt zusätzlich den Vorteil mit sich, daß die Annäherung eines Hubschraubers oder eines Hubschrauberverbandes frühest möglich erkannt wird. Besonders vorteilhaft ist das erfindungsgemäße Verfahren deshalb für eine Frühwarnung/Wecken ohne Sichtverbindung geeignet.

Zur besseren Tarnung fliegen Hubschrauber in aller Regel in sehr geringer Höhe über dem Erdboden im sog. Konturenflug und sind dadurch kaum zu orten. Mit dem erfindungsgemäßen Verfahren kann jedoch schon so frühzeitig eine Hubschraubervorwarnung gegeben werden, daß Zeit für den Einsatz aufwendiger Ortungsverfahren und ein geschicktes Ausbringen zugehöriger Ortungsgeräte vorhanden ist. Diese Ortungsgeräte, die zum Beispiel mit Infrarot- oder höherfrequenten elektromagnetischen Wellen arbeiten, können nunmehr gezielt eingesetzt werden, indem sie erst dann eingeschaltet werden, wenn mit dem erfindungsgemäßen Verfahren eindeutig Hubschrauber detektiert wurden. Energieversorgungsprobleme sowie Verratsmöglichkeiten für diese Ortungsgeräte werden dadurch minimiert und Einsatzzeiten optimiert.

Das erfindungsgemäße Verfahren ist durch künstliche, tiefstfrequente Schallquellen oder andere in der Nähe befindliche Fahrzeuge, z.B. Panzer, nicht zu täuschen oder zu stören, da lediglich Hubschrauber die für die Detektion geforderte Frequenzkonstanz und akustische Leistung einzelner Spektrallinien aufweisen. Wenn mehrere Spektrallinien mit der vorgegebenen Frequenzbreite im Frequenzspektrum bei unterschiedlichen Frequenzen auftreten, sind mehrere Hubschrauber unterschiedlichen Typs detektiert worden. Wenn die Frequenzen jedoch harmonisch zueinander sind, stammen sie vom gleichen Hubschrauber. Diese Unterscheidungen sind aber für die Detektion unerheblich. Der Vorteil des erfindungsgemäßen Verfahrens besteht darin, daß ohne Kenntnis der Frequenzen selbst oder ihrer Harmonischen oder anderer Identifizierungsmerkmale eine eindeutige Detektion möglich ist.

Das erfindungsgemäße Verfahren arbeitet sehr schnell, insbesondere wenn gemäß Anspruch 2 ein Leistungsspektrum des empfangenen Geräuschs mit Hilfe der Fast-Fourier-Transformation ermittelt wird. Die Frequenzauflösung der Fast-Fourier-Transformation wird an die aus den Drehzahltoleranzen ermittelten Frequenzbreite angepaßt. Das Zeitintervall ist dann mindestens gleich dem Reziprokwert der Frequenzbreite zu wählen. Die Pegel der Spektrallinien in den einzelnen benachbarten Frequenzzellen der Fast-Fourier-Transformation werden miteinander verglichen. Befindet sich in geringer Entfernung beispielsweise eine von Panzern befahrene Straße, so weist das empfangene Geräusch Spektrallinien vom abgestrahlten Panzergeräusch und ggf. von einem weit entfernt befindlichen Hubschrauber auf. Die Spektrallinien des Panzergeräuschs sind jeweils über mehrere benachbarte Frequenzzellen verteilt, zum Beispiel über fünf oder zehn Frequenzzellen, während jede Spektrallinie des Hubschraubers nur in einer einzigen Frequenzzelle, maximal zwei, abgespeichert ist. Durch Pegelvergleich benachbarter Frequenzzellen ist nach dem Empfang innerhalb kürzester Zeit eine Detektion möglich, Aufwendige Berechnungsalgorithmen zum Erkennen Harmonischer und Vergleich mit abgespeicherten Mustern sind nicht notwendig.

Der Pegelvergleich wird durch die vorteilhafte Weiterbildung des erfindungsgemäßen Verfahrens nach Anspruch 3 dadurch vereinfacht, daß aus dem Verlauf des Leistungsspektrums, dessen Störhintergrund zu tiefen Frequenzen ansteigt, ein Störspektrum ermittelt wird und das Leistungsspektrum mit dem Störspektrum normiert wird. Besonders vorteilhaft ist es, wenn das Störspektrum durch Mittelung des Leistungsspektrums über ein Frequenzfenster mit Mittelungslücke gewonnen wird, wie es beispielsweise in der DE-OS 30 35 757 beschrieben ist. Die Mittelungslücke ist gleich der Frequenzbreite von Hubschrauberspektrallinie bemessen, so daß bei der Ermittlung des Störhintergrunds für die Hubschrauberspektrallinien diese Spektrallinie ausgespart wird. Durch die anschließende Normierung werden Spektrallinien der vorgegebenen Frequenzbreite besonders stark hervorgehoben, da das Verhältnis zwischen dem spektralen Pegel der Hubschrauberspektrallinie und dem Störhintergrund gebildet wird. Der anschließende Pegelvergleich wird erleichtert. Breitere Spektrallinien werden sicher als Störung erkannt.

Einen weiteren Vorteil bietet die erfindungsgemäße Weiterbildung nach Anspruch 4, da durch die Normierung nach Anspruch 3 eine über der Frequenz im Pegel konstante Detektionsschwelle für den Pegelvergleich verwendet werden kann. Wenn mindestens eine Spektrallinie über der Detektionsschwelle liegt, ist ein Hubschrauber detektiert, wobei die Detektionsschwelle abhängig von der Falschalarmrate einstellbar ist.

Zur weiteren Vergrößerung der Detektionssicherheit, insbesondere wenn mehrere Hubschrauber gleichzeitig in sehr unterschiedlichen Entfernungen in der Luft schweben oder sich im Tiefflug nähern, dient die vorteilhafte Weiterbildung nach Anspruch 5, bei der die Ermittlung des zur Normierung herangezogenen Störspektrums so lange fortgesetzt wird, bis sämtliche Spektrallinien durch ihren Störhintergrund ersetzt sind. Dadurch werden auch dicht benachbarte einzelne Spektrallinien getrennt und kenntlich gemacht. Die Vorgehensweise ist im einzelnen in der o.g. Offenlegungsschrift 30 35 757 angegeben.

Der Vorteil der erfindungsgemäßen Weiterbildung nach Anspruch 6 besteht darin, daß unabhängig von der Lautstärke des Geräuschs die Detektion möglich ist. Es wird aus dem zeitlichen Ablauf von Frequenzspektren des empfangenen Nutz- und Störgeräuschs auf die Annäherung eines Hubschraubers geschlossen. Zuerst werden die spektralen Pegel des für ein Zeitintervall gewonnenen Leistungsspektrums zu einer ersten Summe aufsummiert. Parallel dazu wird gemäß dem Verfahren nach Anspruch 5 ein mit einem speziell die Frequenzbreite berücksichtigenden Störspektrum das momentane Leistungsspektrum normiert und die einzelnen Pegel zu einer zweiten Summe aufsummiert.

Anschließend wird die erste mit der zweiten Summe verglichen. Für das folgende Zeitintervall wird genauso vorgegangen. Solange kein Hubschraubergeräusch empfangen wird, ist die zweite Summe nahezu gleich Null, während die erste Summe einen darüberliegenden Pegel aufweist. Wenn nun ein Hubschraubergeräusch zusätzlich empfangen wird, steigt die zweite Summe stärker als die erste Summe an, da spektrale Pegel mit der vorgegebenen Frequenzbreite im Leistungsspektrum enthalten sind und durch die Normierung stärker hervortreten als bei dem die erste Summe bildenden Leistungsspektrum und dadurch einen größeren Anteil zur zweiten Summe liefern. Der pegelmäßige Abstand der Summen zueinander wird also kleiner und liefert die Hubschrauberdetektion. Gemäß der vorteilhaften Weiterbildung nach Anspruch 7 wird die Differenz der Summen gebildet und gemäß dem Verfahren nach Anspruch 8 mit einer Differenzschwelle verglichen, die abhängig von der Falschalarmrate eingestellt wird.

Besonders einfach ist ein Vergleich zwischen den beiden Summen durchführbar gemäß der vorteilhaften Weiterbildung des erfindungsgemäßen Verfahrens nach Anspruch 9.

Vorrichtungen zum Ausüben des erfindungsgemäßen Verfahrens sind in den Ansprüchen 10 bis 13 angegeben. Die dort genannten Bausteine sind standardmäßig und mit einfachen Mikroprozessoren realisierbar. Auch die anderen zu verwendenden Komponenten sind aus der Rechnertechnik geläufig. Insbesondere die Normierungsschaltung zum Ermitteln von Mittelwertpegelverläufen des Leistungsspektrums oder eines Störspektrums ist in der vorher genannten deutschen Offenlegungsschrift DE-OS 30 35 757 ausführlich beschrieben. Der Vorteil der Vorrichtungen zum Ausüben des erfindungsgemäßen Verfahrens bestehen insbesondere darin, daß bei geringem Energieverbrauch eine eindeutige Frühwarnung vor Hubschraubern mit hoher Trefferwahrscheinlichkeit erzielt werden kann.

Das erfindungsgemäße Verfahren zum Unterscheiden weit entfernter, in der Luft befindlicher Hubschrauber von anderen Fahrzeugen ist in einem Ausführungsbeispiel in Form eines Blockschaltbildes näher erläutert. Es zeigen:

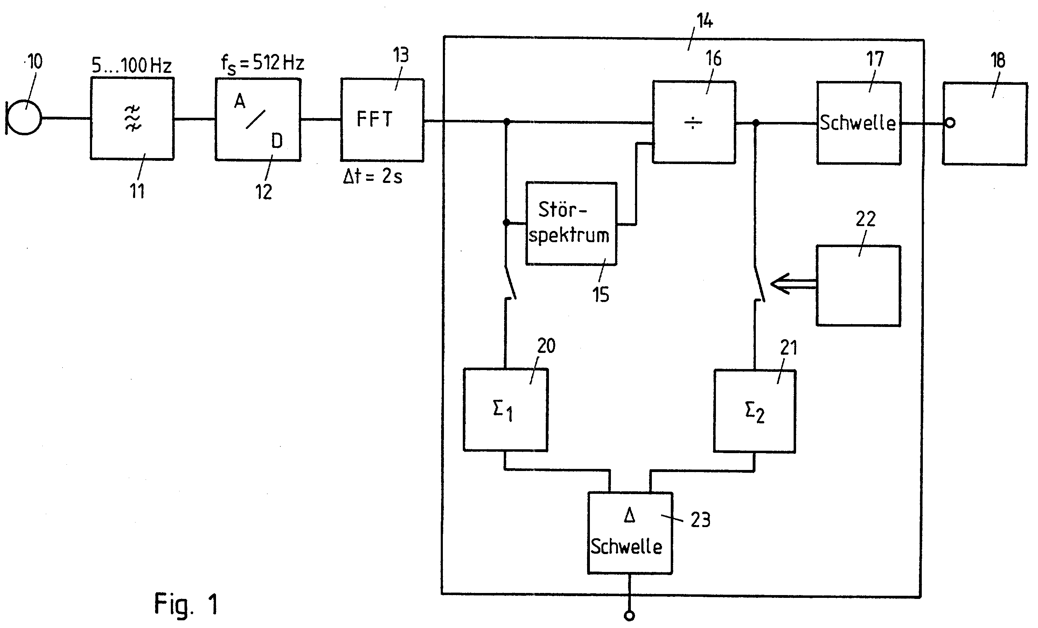

- Fig. 1: das Blockschaltbild,
- Fig. 2: einen prinzipiellen Verlauf eines Leistungsspektrums, das ein Hubschraubergeräusch enthält,
- Fig. 3: ein normiertes Leistungsspektrum und
- Fig. 4: Summen der spektralen Pegel des Leistungsspektrums und des normierten Leistungsspektrums über der Zeit.

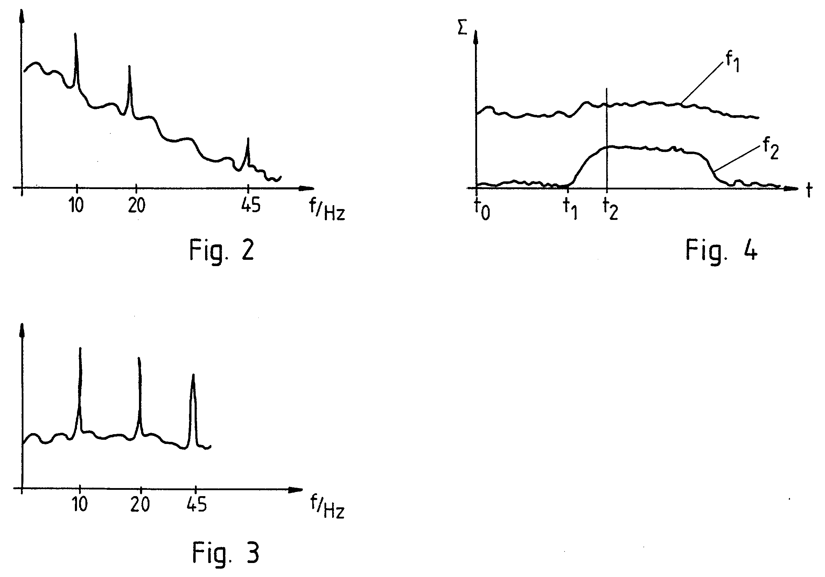

Mit einem Mikrophon 10 werden Geräusche empfangen und in ihrem Frequenzumfang durch einen nachgeschalteten Bandpaß 11 auf einen unteren Frequenzbereich von 5 bis 100 Hz begrenzt. Erfahrungsgemäß und durch die Aerodynamik bedingt liegt die Drehzahl des Hauptrotors eines Hubschraubers abhängig vom Hubschraubertyp im Frequenzbereich von einigen Hz bis 35 Hz, beispielsweise bei 10 Hz, und die Heckrotorfrequenz beim ungefähr zwei- bis fünffachen Wert der Hauptrotorfrequenz, beispielsweise bei 45 Hz. Dem Bandpaß 11 ist ein Analog/Digital-Wandler 12 nachgeordnet, der das analoge Ausgangssignal des Bandpasses 11 mit einer Abtastfrequenz von 512 Hz abtastet. Ein nachgeschalteter Frequenzanalysator 13 ist durch einen Fast-Fourier-Transformator mit vorgeschaltetem Wechselspeicher realisiert, in den jeweils innerhalb eines Zeitintervalls von zwei Sekunden das digitalisierte, bandbegrenzte Geräusch eingespeichert wird. Der Fast-Fourier-Transformator weist 1024 Frequenzzellen für gleich große Frequenzintervalle von ½ Hz Breite auf und liefert ein Leistungsspektrum des bandbegrenzten Geräusches, das in Fig. 2 dargestellt ist.

Das Leistungsspektrum in Fig. 2 weist ein von niedrigen zu hohen Frequenzen abfallendes Grundgeräuschspektrum und drei Spektrallinien bei den Frequenzen 10, 20 und 45 Hz auf. Diese drei Spektrallinien stammen von einem weit entfernten Hubschrauber, dessen Hauptrotorfrequenz bei 10 Hz liegt, die erste Harmonische bei 20 Hz und die Heckrotorgrundfrequenz bei 45 Hz.

Mit dem erfindungsgemäßen Verfahren wird nun in einer dem Frequenzanalysator 13 nachgeordneten Pegelvergleichsschaltung 14 untersucht, ob die Energie der Spektrallinien eine vorgegebene Frequenzbreite aufweisen, die bei der Frequenz 10 Hz gerade gleich 0,2 Hz ist, da die Hauptrotordrehzahl typischerweise um weniger als 2 % schwankt. Bei der Frequenzzelle 10 Hz liegt eine Spektrallinie vor. Es wird geprüft, ob die Frequenzbreite dieser Spektrallinie gleich der vorgegebenen Frequenzbreite von 0,2 Hz ist und nur die Frequenzzelle bei 10 Hz füllt und nicht darüber hinaus benachbarte Frequenzzellen bei 9,5 oder 10,5 Hz belegt. Dazu werden drei Frequenzzellen im Bereich um 10 Hz bezüglich ihrer Pegels miteinander verglichen. Wenn in den benachbarten Frequenzzellen, also bei 9½ Hz und bei 10½ Hz wesentlich geringere Pegel auftreten als in der dazwischen liegenden Frequenzzelle, stammt die Spektrallinie bei 10 Hz von einem Hubschrauber.

Für den Vergleich der Spektrallinien ist in der Pegelvergleichsschaltung 14 eine Anordnung 15 zum Ermitteln von Mittelwertpegelverläufen aus dem Leistungsspektrum am Ausgang des Frequenzanalysators 13 oder eines Störspektrums, wie es in der Offenlegungsschrift DE-OS 30 35 757 beschrieben ist, vorgesehen. Der Anordnung 15 ist eine Normierungsschaltung 16 nachgeordnet, in der das Leistungsspektrum mit dem Störspektrum am Ausgang der Anordnung 15 normiert wird. Die Normierungsschaltung 16 besteht beispielsweise wegen der großen Dynamik ihrer Eingangssignale aus zwei Logarithmierstufen und einer Differenzstufe, so daß am Ausgang ein normiertes Spektrum ansteht, dessen Pegelwerte logarithmiert sind, wie in Fig. 3 gezeigt. Der Normierungsschaltung 16 ist ein Schwellendetektor 17 nachgeordnet, in dem abhängig von einer zugelassenen Falschalarmrate eine Detektionsschwelle eingestellt ist, mit der das normierte Spektrum verglichen wird. Wenn einer oder mehrere spektrale Pegel über der Detektionsschwelle liegen, wird Hubschrauberalarm in einer nachgeordneten Detektionsanzeige 18 gemeldet.

Eine andere Variante zum Pegelvergleich, die zusätzlich oder getrennt vom ersten Pegelvergleich durchgeführt werden kann, besteht darin, daß in der Pegelvergleichsschaltung 14 eine erste und zweite Rechenschaltung 20, 21 zum Bilden einer ersten und zweiten Summe vorgesehen ist. Diese Rechenschaltungen 20, 21 sind über einen betätigbaren Schalter 22 zuschaltbar. In der ersten Rechenschaltung 20 wird je Zeitintervall die Summe S₁ der spektralen Pegel des Leistungsspektrums am Ausgang des Frequenzanalysators 13 gebildet, deren Verlauf über der Zeit t in Fig. 4 dargestellt ist. Während der Zeit t₀ bis t₁ wird nur Umgebungs- oder Störgeräusch empfangen. In dem Geräusch ist kein Hubschraubergeräusch enthalten. Zur Zeit t₁ beginnt der Anflug eines Hubschraubers. Am Ausgang der ersten Rechenschaltung 20 steigt die Summe S₁ geringfügig an und nimmt bis zum Zeitpunkt t₂ zu.

In der zweiten Rechenschaltung 21 werden die Pegel des normierten Spektrums am Ausgang der Normierungsschaltung 16 je Zeitintervall zur Summe S₂ aufsummiert, das im Zeitraum von t₀ bis t₁ nahezu 0 ist, da keine schmalbandigen Spektrallinien mit der vorgebbaren Frequenzbreite empfangen werden. Breitere Spektrallinien, z. B. von Panzern verursacht, werden in der Normierungsschaltung 16 ausnivelliert. Nur die sehr schmalbandigen Spektrallinien des Hubschraubers werden stark betont und tragen dadurch zur Summenbildung erheblich mehr bei als bei der Summenbildung des nicht normierten Leistungsspektrums. Ein Vergleich der beiden Summen S₁ und S₂ zum Zeitpunkt t₂ zeigt, daß die Differenz der beiden Summen S₁ und S₂ geringer als in der Zeit zwischen t₀ und t₁ ist. Dieser Vergleich wird in einer den Rechenschaltungen 20 und 21 nachgeschalteten Vergleichsschaltung 23 durchgeführt und führt zur Detektion oder ihrer Bestätigung, wenn die Differenz der Summen S₁ und S₂ eine vorgegebene Differenzschwelle unterscheidet. Eine weitere Möglichkeit besteht darin, daß die zweite Summe S₂ mit einem Faktor multipliziert wird, der den Unterschied der Summen S₁, S₂ bei Vorliegen mindestens einer Spektrallinie eines Hubschraubers berücksichtigt. Die mit dem Faktor multiplizierte Summe S₂ wird mit der Summe S₁ verglichen und liefert bei Gleichheit oder Überschreiten die Detektion des Hubschraubers.

## Patentansprüche

1. Verfahren zum Detektieren und Unterscheiden weit entfernter, in der Luft befindlicher Hubschrauber von anderen Fahrzeugen, bei dem Geräusche empfangen und bezüglich ihrer Spektrallinien ausgewertet werden, dadurch gekennzeichnet, daß eine Frequenzbreite abhängig von ein stabiles Flugverhalten garantierenden, zulässigen Drehzahlschwankungen des Hauptrotors vorgegeben wird, daß ein Zeitintervall mindestens gleich dem Reziprokwert der Frequenzbreite bestimmt wird und daß niederfrequente Spektrallinien innerhalb des vorgegebenen Zeitintervalls mit Frequenzschwankungen innerhalb der vorgegebenen Frequenzbreite gesucht werden und daß bei Auftreten von mindestens einer solchen Spektrallinie ein Hubschrauber detektiert wird.

2. Verfahren nach Anspruch 1, dadurch gekennzeichnet, daß der Frequenzbereich in aneinandergrenzende, gleichgroße Frequenzintervalle aufgeteilt wird und jedes Frequenzintervall höchstens gleich der vorgebbaren Frequenzbreite ist, daß die im unteren Frequenzbereich auszuwertenden Geräusche in ein Leistungsspektrum mit einer Frequenzauflösung umgewandelt werden, die gleich dem Frequenzintervall ist, daß Pegel benachbarter Frequenzintervalle innerhalb der Frequenzbreite verglichen werden und ein gegenüber benachbarten Pegeln herausragender Pegel die gesuchte Spektrallinie ist.

3. Verfahren nach Anspruch 2, dadurch gekennzeichnet, daß Mittelwerte des Leistungsspektrums über der Frequenz innerhalb eines Frequenzfensters mit einer Mittelungslücke gewonnen werden, daß die Mittelungslücke des Frequenzfensters gleich der vorgegebenen Frequenzbreite ist, wobei das Frequenzfenster längs der Frequenz sukzessive über das Leistungsspektrum geschoben wird und einen ersten Mittelwertpegelverlauf über der Frequenz liefert, daß das Leistungsspektrum mit dem ersten Mittelwertpegelverlauf normiert wird und das normierte Spektrum auf herausragende Pegel untersucht wird.

4. Verfahren nach Anspruch 3, dadurch gekennzeichnet, daß das normierte Spektrum mit einer von einer vorgebbaren Falschalarmrate abhängigen Detektionsschwelle verglichen wird und bei Überschreiten die Spektrallinie gefunden ist.

5. Verfahren nach Anspruch 3 oder 4, dadurch gekennzeichnet, daß herausragende Pegel des normierten Spektrums durch die bei diesen Frequenzen vorliegenden Mittelwerte ersetzt werden und ein erstes linienbereinigtes Spektrum liefern, daß mit dem Frequenzfenster und seiner Mittelungslücke ein zweiter Mittelwertpegelverlauf des ersten linienbereinigten Spektrums gewonnen und ins Verhältnis mit dem ersten linienbereinigten Spektrum gesetzt wird und iterativ so lange fortgefahren wird, bis ein Störspektrum bestimmt ist, bei dem sämtliche Spektrallinien eingeebnet sind und dieses Störspektrum zur Normierung des Leistungsspektrums verwendet wird und auf herausragende Pegel untersucht wird.

6. Verfahren nach Anspruch 5, dadurch gekennzeichnet, daß je Zeitintervall eine erste Summe aller Pegel des Leistungsspektrums über der Frequenz und eine zweite Summe aller Pegel des normierten Leistungsspektrums über der Frequenz gebildet werden und der zeitliche Verlauf beider Summen miteinander verglichen wird, daß bei stärkerem Anstieg der zweiten Summe gegenüber der ersten Summe mindestens eine Spektrallinie mit der vorgegebenen Frequenzbreite gefunden ist.

7. Verfahren nach Anspruch 6, dadurch gekennzeichnet, daß die Differenz der ersten und zweiten Summe gebildet wird und bei signifikanter Verkleinerung der Differenz mindestens eine Spektrallinie mit der vorgegebenen Frequenzbreite gefunden ist.

8. Verfahren nach Anspruch 7, dadurch gekennzeichnet, daß die Differenz mit einer von der Falschalarmrate abhängigen Differenzschwelle verglichen wird und bei Unterschreiten mindestens eine Spektrallinie mit der vorgegebenen Frequenzbreite gefunden ist.

9. Verfahren nach Anspruch 8, dadurch gekennzeichnet, daß die zweite Summe mit einem Faktor multipliziert wird, der den Unterschied der beiden Summen bei Vorliegen von Spektrallinien vorgegebener Frequenzbreite berücksichtigt, daß die erste Summe mit der bewerteten zweiten Summe verglichen und mindestens eine Spektrallinie mit vorgegebener Frequenzbreite gefunden ist, wenn die bewertete zweite Summe gleich oder größer als die erste Summe ist.

10. Vorrichtung zum Detektieren und Unterscheiden weit entfernter, in der Luft befindlicher Hubschrauber von anderen Fahrzeugen, mit einem Mikrophon (10) zum Empfangen ihrer Geräusche und einem Frequenzanalysator (13) zur Auswertung der Spektrallinien dieser Geräusche, zur Durchführung des Verfahrens nach Anspruch 1, dadurch gekennzeichnet, daß zwischen Mikrophon (10) und Frequenzanalysator (13) ein Tiefpaß oder Bandpaß (11) mit einer oberen Grenzfrequenz unter 500 Hz geschaltet ist, daß die Frequenzauflösung im Frequenzanalysator mindestens gleich der Frequenzbreite ist, welche von ein stabiles Flugverhalten garantierenden Drehzahlschwankungen des Hauptrotors eines Hubschraubers abgeleitet ist, und daß dem Frequenzanalysator (13) eine Pegelvergleichsschaltung (14) zum Vergleich der Spektrallinien für in Abständen der Frequenzbreite benachbarte spektrale Pegel nachgeordnet ist, wobei bei Auftreten eines gegenüber benachbarten Pegeln herausragenden Pegels der Hubschrauber detektiert ist.

11. Vorrichtung nach Anspruch 10 zum Ausüben des Verfahrens nach Anspruch 2, dadurch gekennzeichnet, daß der Frequenzanalysator (13) ein Fast-Fourier-Transformator zum Bilden eines Leistungsspektrums ist, deren trennbare Frequenzintervalle maximal gleich der Frequenzbreite sind.

12. Vorrichtung nach Anspruch 10 oder 11 zum Ausüben des Verfahrens nach einem der Ansprüche 3, 4 oder 5, dadurch gekennzeichnet, daß die Pegelvergleichsschaltung (14) eine Anordnung (15) zum Ermitteln von Mittelwertpegelverläufen oder eines Störspektrums aus dem Leistungsspektrum, eine nachgeschaltete Normierungsschaltung (16) zum Bilden eines normierten Spektrums, die mit dem Leistungsspektrum beaufschlagt ist, und einen Schwellendetektor aufweist.

13. Vorrichtung nach Anspruch 12 zum Ausüben des Verfahrens nach einem der Ansprüche 6 bis 9, dadurch gekennzeichnet, daß in der Pegelvergleichsschaltung (14) eine erste und zweite Rechenschaltung (20, 21) zum Bilden einer ersten Summe aus den Pegeln des Leistungsspektrums und einer zweiten Summe aus den Pegeln des normierten Leistungsspektrums enthalten ist, daß die erste Rechenschaltung (20) mit dem Frequenzanalysator (13) und die zweite Rechenschaltung (21) mit der Normierungsschaltung (16) eingangsseitig und ausgangsseitig mit einer Vergleichsschaltung (23) verbunden sind.

## Claims

1. Process for detecting and discriminating airborne helicopters from other vehicles at long distance, in which noise signals are received and evaluated with respect to their spectral lines, characterised in that a frequency width dependent on permissible fluctuations in speed of the main rotor guaranteeing a stable flight performance is preset; that a time interval at least equal to the reciprocal value of the frequency width is determined; and that low-frequency spectral lines are searched for within the preset time interval with frequency fluctuations within the preset frequency width; and that when at least one such spectral line occurs, a helicopter is detected.

2. Process according to Claim 1, characterised in that the frequency range is divided into adjoining frequency intervals of equal magnitude, and each frequency interval is at maximum equal to the frequency width, which may be preset; that the noise signals to be evaluated in the lower frequency range are converted into a power spectrum with a frequency resolution, which is equal to the frequency interval; that levels of adjacent frequency intervals are compared within the frequency width, and a level projecting beyond adjacent levels is the spectral line searched for.

3. Process according to Claim 2, characterised in that mean values of the power spectrum over the frequency are obtained within a frequency window with an averaging gap; that the averaging gap of the frequency window is equal to the preset frequency width, whereby the frequency window is shifted along the frequency successively over the power spectrum and supplies a first mean level curve; that the power spectrum is normalised with the first mean level curve and the normalised spectrum is examined for projecting levels.

4. Process according to Claim 3, characterised in that the normalised spectrum is compared with a detection threshold dependent on a false alarm rate, which may be preset, and the spectral line is found when this is exceeded.

5. Process according to Claim 3 or 4, characterised in that projecting levels of the normalised spectrum are replaced by the mean values present at these frequencies and provide a first spectrum freed from lines; that a second mean level curve of the first spectrum freed from lines is obtained with the frequency window and its averaging gap and is brought into proportion with the first spectrum freed from lines and is continued iteratively until a disturbance spectrum is determined, in the case of which all the spectral lines are rendered level, and this disturbance spectrum is used for normalisation of the power spectrum and examined for projecting levels.

6. Process according to Claim 5, characterised in that for each time interval, a first sum of all the levels of the power spectrum over the frequency and a second sum of all the levels of the power spectrum over the frequency are formed, and the time curves of both sums are compared with one another; that in the case of a steeper upward gradient of the second sum in relation to the first sum, at least one spectral line with the preset frequency width is found.

7. Process according to Claim 6, characterised in that the difference in the first and second sum is formed, and in the case of significant reduction of the difference, at least one spectral line with the preset frequency width is found.

8. Process according to Claim 7, characterised in that the difference is compared with one difference threshold dependent on the false alarm rate and when this is exceeded, at least one spectral line with the preset frequency width is found.

9. Process according to Claim 8, characterised in that the second sum is multiplied by a factor which takes into account the difference in the two sums when spectral lines are present; that the first sum is compared with the computed second sum and at least one spectral line with the present frequency is found if the computed second sum is equal to or greater than the first sum.

10. Device for detecting and discriminating airborne helicopters from other vehicles at long distance, having a microphone (10) for receiving their noise signals and a frequency analyser (13) for evaluating the spectral lines of these noise signals, for conducting the process according to Claim 1, characterised in that a low-pass or band-pass filter (11) with an upper limit frequency below 500 Hz is connected between the microphone (10) and the frequency analyser (13); that the frequency resolution in the frequency analyser is at least equal to the frequency width, which is derived from fluctuations in speed of the main rotor of a helicopter guaranteeing a stable flight performance; and that a level comparison circuit (14) for comparing the spectral lines for spectral levels spaced adjacent to the frequency width is located downline of the frequency analyser (13), whereby the helicopter is detected when a level projecting beyond adjacent levels occurs.

11. Device according to Claim 10 for performing the process according to Claim 2, characterised in that the frequency analyser (13) is a fast Fourier transformer for forming a power spectrum, the separable frequency intervals of which are at maximum equal to the frequency width.

12. Device according to Claim 10 or 11 for performing the process according to one of Claims 3, 4 or 5, characterised in that the level comparison circuit (14) has an arrangement (15) for determining mean level curves or a disturbance spectrum from the power spectrum, a normalisation spectrum (16) connected downline for forming a normalised spectrum, to which the power spectrum is applied, and a threshold detector.

13. Device according to Claim 12 for performing the process according to one of Claims 6 to 9, characterised in that a first and second computing circuit (20, 21) is contained in the level comparison circuit (14) for forming a first sum from the levels of the power spectrum and a second sum from the levels of the normalised power spectrum; that the first computing circuit (20) is connected to the frequency analyser (13) and the second computing circuit (21) is connected on the input side to the normalisation circuit (16) and on the output side to a comparison circuit (23).

## Revendications

1. Procédé pour détecter et distinguer vis-à-vis d'autres véhicules, des hélicoptères très éloignés se trouvant en l'air, dans lequel des bruits sont reçus et évalués relativement à leurs raies spectrales, caractérisé en ce qu'une largeur de fréquence est prédéterminée en fonction de fluctuations admissibles de vitesse de rotation du rotor principal garantissant un comportement stable en vol, qu'un intervalle de temps au moins égal à l'inverse de la largeur de fréquence est déterminé et que des raies spectrales à basse fréquence pendant l'intervalle prédéterminé de temps sont recherchées, et que lors de l'apparition d'au moins une de ces raies spectrales un hélicoptère est détecté.

2. Procédé selon la revendication 1, caractérisé en ce que le domaine de fréquences est divisé en des intervalles de fréquences consécutifs de même valeur et que chaque intervalle de fréquences est au maximum égal à la largeur prédéterminée de fréquence, que les bruits à évaluer dans le domaine inférieur de fréquences sont convertis en un spectre de puissance avec une définition en fréquence qui est égale à l'intervalle de fréquences, que des niveaux d'intervalles voisins de fréquences dans la largeur de fréquence sont comparés et qu'un niveau dépassant les niveaux voisins est la raie spectrale recherchée.

3. Procédé selon la revendication 2, caractérisé en ce que des valeurs moyennes du spectre de puissance sont acquises pour la fréquence à l'intérieur d'une fenêtre de fréquence avec un intervalle de calcul de moyenne, que l'intervalle de calcul de moyenne de la fenêtre de fréquences est égal à la largeur prédéterminée de fréquence, dans lequel la fenêtre de fréquence est déplacée successivement le long de la fréquence sur le spectre de puissance et fournit une première évolution de niveau de valeur moyenne pour la fréquence, que le spectre de puissance est normalisé avec la première évolution de niveau de valeur moyenne, et dans le spectre normalisé un niveau exceptionnel est recherché.

4. Procédé selon la revendication 3, caractérisé en ce que le spectre normalisé est comparé à un seuil de détection dépendant d'un taux prévisible de fausses alertes et que lors d'un dépassement la raie spectrale est trouvée.

5. Procédé selon la revendication 3 ou 4, caractérisé en ce que des niveaux exceptionnels du spectre normalisé sont remplacés par les valeurs moyennes présentes à ces fréquences et fournissent un premier spectre en forme de ligne lissée, qu'avec la fenêtre de fréquence et son intervalle de calcul de moyenne une deuxième évolution de niveau de valeur moyenne du premier spectre en forme de ligne lissée est obtenue et est fixée en relation avec le premier spectre en forme de ligne lissée et est poursuivi de manière itérative, jusqu'à ce qu'un spectre parasite soit déterminé dans lequel toutes les raies spectrales sont nivelées et ce spectre parasite est utilisé pour standardiser le spectre de puissance et est analysé pour rechercher des niveaux exceptionnels.

6. Procédé selon la revendication 5, caractérisé en ce qu'à chaque intervalle de temps, une première somme de tous les niveaux du spectre de puissance pour la fréquence et une deuxième somme de tous les niveaux du spectre normalisé de puissance pour la fréquence sont formées, et que l'évolution dans le temps des deux sommes est comparée l'une avec l'autre, que lors d'une forte augmentation de la deuxième somme par rapport à la première somme, au moins une raie spectrale est trouvée avec la largeur prédéterminée de fréquence.

7. Procédé selon la revendication 6, caractérisé en ce que la différence des deuxième et première sommes est formée et que, lors d'une diminution importante de la différence, au moins une raie spectrale est trouvée avec la largeur prédéterminée de fréquence.

8. Procédé selon la revendication 7, caractérisé en ce que la différence est comparée à un seuil de différence dépendant du taux de fausses alertes et que lors d'un dépassement, au moins une raie spectrale est trouvée avec la largeur prédéterminée de fréquence.

9. Procédé selon la revendication 8, caractérisé en ce que la deuxième somme est multipliée par un facteur qui tient compte de la différence des deux sommes lors de la présence de raies spectrales de largeur prédéterminée de fréquence, que la première somme est comparée à la deuxième somme évaluée et qu'au moins une raie spectrale est trouvée avec la largeur prédéterminée de fréquence quand la deuxième somme évaluée est égale ou supérieure à la première somme.

10. Dispositif pour détecter et distinguer vis-à-vis d'autres véhicules, des hélicoptères très éloignés se trouvant en l'air, avec un microphone (10) pour recevoir leurs bruits et un analyseur de fréquence (13) pour évaluer les raies spectrales de ces bruits, pour mettre en oeuvre le procédé selon la revendication 1, caractérisé en ce qu'entre le microphone (10) et l'analyseur de fréquence (13) un filtre passe-bas ou passe-bande (11) est inséré avec une fréquence supérieure de coupure inférieure à 500 Hz, que la définition en fréquence de l'analyseur de fréquence est au moins égale à la largeur de fréquence qui est obtenue à partir des fluctuations de vitesse de rotation du rotor principal d'un hélicoptère garantissant un comportement stable en vol, et qu'un circuit de comparaison de niveau (14) est associé à l'analyseur de fréquence (13) pour comparer les raies spectrales voisines pour des niveaux spectraux à des distances de la largeur de fréquence, afin que, lors de l'apparition d'un niveau exceptionnel par rappport à des niveaux voisins, l'hélicoptère soit détecté.

11. Dispositif selon la revendication 10 pour mettre en oeuvre le procédé selon la revendication 2, caractérisé en ce que l'analyseur de fréquence (13) est un générateur de transformation de Fourier rapide pour former un spectre de puissance, dont l'intervalle séparable de fréquence est au maximum égal à la largeur de fréquence.

12. Dispositif selon la revendication 10 ou 11 pour mettre en oeuvre le procédé selon l'une des revendications 3, 4 ou 5, caractérisé en ce que le circuit de comparaison de niveau (14) présente un dispositif (15) pour déterminer des évolutions de niveau de valeur moyenne ou d'un spectre parasite à partir du spectre de puissance, un circuit de normalisation (16), monté en aval pour former un spectre normalisé, qui est alimenté par le spectre de puissance, et un détecteur de seuil.

13. Dispositif selon la revendication 12 pour mettre en oeuvre le procédé selon l'une des revendications 6 à 9, caractérisé en ce que, dans le circuit de comparaison de niveau (14), des premier et deuxième circuits de calcul (20, 21) sont inclus pour former une première somme à partir des niveaux du spectre de puissance et une deuxième somme à partir des niveaux du spectre normalisé de puissance, que le premier circuit de calcul (20) est relié à l'analyseur de fréquence (13) et le deuxième circuit de calcul (21), au circuit de normalisation (16) du côté de l'entrée, et qu'ils sont reliés du côté de la sortie à un circuit de comparaison (23).
